# EUROPEAN PATENT APPLICATION

(11) **EP 4 768 965 A1**
(43) Date of publication of application: **01.07.2026**
(21) Application number: 25863895.6
(22) Date of filing: 06.08.2025
(51) Int. Cl.: G01R 31/392, G01R 31/3835, G01R 31/367, G01R 31/396, H01M 10/48

(54) **BATTERY DIAGNOSIS APPARATUS AND BATTERY DIAGNOSIS METHOD**

(30) Priority: 09.09.2024 KR 20240122464; 25.02.2025 KR 20250024292
(71) Applicant: LG Energy Solution, Ltd., Seoul 07335 (KR)
(72) Inventor: CHOI, Hyun Jun, Daejeon 34122 (KR); KIM, Hye Yeong, Daejeon 34122 (KR); KIM, Young Deok, Daejeon 34122 (KR)
(74) Representative: Goddar, Heinz J.
(86) International application number: PCT/KR2025/011802
(87) International publication number: WO 2026/054345

(57) **Abstract**

According to an embodiment disclosed in this document, there is provided a battery diagnosis device including an interface configured to acquire a temperature profile representing a temperature change of a battery cell with respect to a voltage change of the battery cell and a capacity profile representing a capacity change of the battery cell with respect to a voltage change of the battery cell and at least one processor, in which the at least one processor is configured to identify a first peak value representing a phase transition of the battery cell based on the temperature profile, and estimate a degree of degradation representing a degree of degradation of the battery cell based on identifying a first point corresponding to the first peak value in the capacity profile.

## Description

### TECHNICAL FIELD

### Cross-reference to Related Applications

This application claims priority from Korean Patent Application Nos. 10-2024-0122464, filed on September 9, 2024, and 10-2025-0024292, filed on February 25, 2025, the disclosures of which are incorporated by reference herein.

### Technical Field

Embodiments disclosed in this document relate to a battery diagnosis device and a battery diagnosis method.

### BACKGROUND ART

Battery data used in battery cell diagnosis may include peak values that exhibit different characteristics depending on the charging rate. For example, battery data acquired based on relatively fast charging rates may not include peak values representing phase transitions occurring at the negative electrode. Therefore, a method for identifying a phase equilibrium state or phase transition state occurring within a battery may be required independently of the charging speed used to acquire the battery data.

### DISCLOSURE OF THE INVENTION

### TECHNICAL PROBLEM

Embodiments disclosed in this document provide a battery diagnosis device and a battery diagnosis method for diagnosing a degree of degradation of a battery using a temperature profile.

Embodiments disclosed in this document provide a battery diagnosis device and a battery diagnosis method for diagnosing the degree of degradation of the battery by inferring a point of a capacity profile using a temperature profile.

The technical problems of the embodiments disclosed in the document are not limited to the technical problems mentioned above, and other technical problems not mentioned will be clearly understood by those skilled in the art from the descriptions below.

### TECHNICAL SOLUTION

According to an embodiment disclosed in this document, there is provided a battery diagnosis device including an interface configured to acquire a temperature profile representing a temperature change of a battery cell with respect to a voltage change of the battery cell and a capacity profile representing a capacity change of the battery cell with respect to the voltage change of the battery cell and at least one processor, in which the at least one processor is configured to identify a first peak value representing a phase transition of the battery cell based on the temperature profile, and estimate a degree of degradation, which indicates a degree to which the battery cell has degraded, based on identifying a first point corresponding to the first peak value in the capacity profile.

For example, the at least one processor may be configured to acquire the temperature profile and the capacity profile during a process of charging or discharging the battery cell.

For example, the first point may represent a high potential phase transition state occurred at a negative electrode of the battery cell.

For example, the at least one processor may be configured to identify a second point different from the first point based on the capacity profile and estimate the degree of degradation based on a difference between the first point and the second point.

For example, the at least one processor may be configured to estimate the degree of degradation by comparing the difference between the first point and the second point with a designated difference.

For example, the second point may exhibit a phase transition state different from a high potential phase transition state corresponding to the first point.

For example, the at least one processor may be configured to acquire the temperature profile through the interface including a temperature sensor attached to the battery cell.

For example, the at least one processor may be configured to control a charge amount of the battery cell when the degree of degradation of the battery exceeds a degree of designated degradation.

According to another embodiment disclosed in this document, there is provided a battery diagnosis method including an operation of identifying a first peak value representing a phase transition of a battery cell based on a temperature profile representing a temperature change of the battery cell with respect to a voltage change of the battery cell and an operation of estimating a degree of degradation, which indicates a degree to which the battery cell has degraded, based on identifying a first point corresponding to the first peak value in a capacity profile representing a capacity change of the battery cell with respect to the voltage change of the battery cell.

For example, the battery diagnosis method may include an operation of acquiring the temperature profile and the capacity profile during a process of charging or discharging the battery cell.

For example, the operation of estimating the degree of degradation may include an operation of identifying a second point different from the first point based on the capacity profile and an operation of estimating the degree of degradation based on a difference between the first point and the second point.

For example, the operation of estimating the degree of degradation may further include an operation of estimating the degree of degradation by comparing the difference between the first point and the second point with a designated difference.

For example, the second point may exhibit a phase transition state different from a high potential phase transition state corresponding to the first point.

For example, the battery diagnosis method may include an operation of acquiring the temperature profile through the interface including a temperature sensor attached to the battery cell.

For example, the battery diagnosis method may include an operation of controlling a charge amount of the battery cell when the degree of degradation of the battery exceeds a designated degree of degradation.

### ADVANTAGEOUS EFFECTS

The battery diagnosis device and battery diagnosis method according to the embodiments disclosed in this document can diagnose the degree of degradation of the battery using the temperature profile.

The battery diagnosis device and battery diagnosis method according to the embodiments disclosed in this document can diagnose the degree of degradation of the battery by inferring a point of the capacity profile using the temperature profile.

In addition, various effects that are directly or indirectly identified through this document can be provided.

### BRIEF DESCRIPTION OF THE DRAWINGS

FIG. 1 is a block diagram showing a battery pack according to an embodiment disclosed in this document.
FIG. 2 is a block diagram illustrating the configuration of a battery diagnosis device according to an embodiment disclosed in this document.
FIG. 3 illustrates an example of a graph representing data related to a battery cell according to an embodiment disclosed in this document.
FIG. 4 illustrates an example of a graph representing data related to a battery cell according to an embodiment disclosed in this document.
FIG. 5 illustrates an example of a graph representing data related to a battery cell according to an embodiment disclosed in this document.
FIG. 6 shows an example of a flowchart illustrating an operation performed by a battery diagnosis device according to an embodiment disclosed in this document.
FIG. 7 illustrates a computing system executing a battery diagnosis method according to an embodiment disclosed in this document.

### MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

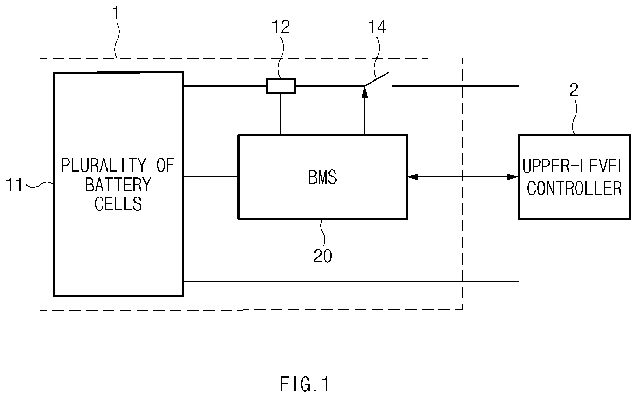

FIG. 1 is a block diagram showing a battery pack according to an embodiment disclosed in this document.

Referring to FIG. 1, a battery control system including a battery pack 1 and an upper-level controller 2 included in an upper-level system according to an embodiment disclosed in this document is schematically illustrated.

As illustrated in FIG. 1, the battery pack 1 may include a plurality of battery cells 11, a switching unit 14 connected in series to a first terminal side and/or a second terminal side of the plurality of battery cells 11 to control a charge and/or discharge current flow of the plurality of battery cells 11, and a battery management system 20 that monitors the voltage, current, temperature, etc. of the battery pack 1 to prevent overcharging and overdischarging.

In this case, the battery pack 1 may be equipped with a plurality of the plurality of cells 11, sensors 12, switching units 14, and battery management systems 20. For example, a first terminal may be a positive (+) terminal of the plurality of battery cells 11, and a second terminal may be a negative (-) terminal thereof.

Here, the switching unit 14 is a device for controlling the current flow for charging or discharging the plurality of battery cells 11, and for example, at least one relay, magnetic contactor, etc. may be used depending on the specifications of the battery pack 1.

For example, the plurality of battery cells 11 may include a cylindrical battery. The cylindrical battery may refer to a battery in which battery materials are packaged in a cylindrical shape. Since the plurality of battery cells 11 include cylindrical batteries, if lithium deposition occurs inside the cylindrical batteries during constant voltage charging of the plurality of battery cells 11, a phenomenon in which the current flowing through the plurality of battery cells 11 increases may occur.

The battery management system 20 is an interface that receives values obtained by measuring various parameters described above, and may include a plurality of terminals, a circuit connected to these terminals and performs processing of the received values, etc. In addition, the battery management system 20 may control the ON/OFF of the switching unit 14, for example, a relay or a contactor, and may be connected to the battery cell 11 to monitor the state of each of the plurality of battery cells 11.

The upper-level controller 2 may transmit a control signal for the plurality of battery cells 11 to the battery management system 20. Accordingly, the operation of the battery management system 20 may be controlled based on a signal applied from the upper-level controller 2.

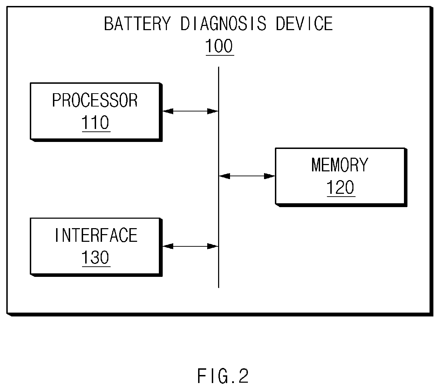

According to the embodiment, the battery management system 20 may include a battery diagnosis device 100 of FIG. 2. According to another embodiment, the battery management system 20 may be another system different from the battery diagnosis device 100 of FIG. 2. That is, the battery diagnosis device 100 of FIG. 2 may be included in the battery pack 1 or may be configured as another device external to the battery pack 1. For convenience of description, it will be described on the premise that the battery diagnosis device 100 is configured as another device external to the battery pack 1.

FIG. 2 is a block diagram illustrating the configuration of a battery diagnosis device according to an embodiment disclosed in this document.

The battery diagnosis device 100 according to an embodiment may include at least one of a processor 110, a memory 120, and an interface 130. The processor 110, the memory 220, and the interface 130 may be electronically and/or operably coupled with each other by an electronic component including a communication bus. Hereinafter, operably coupling pieces of hardware with each other may mean a direct connection and/or an indirect connection between pieces of hardware being established in a wired manner and/or wirelessly, such that a second piece of hardware is controlled by a first piece of hardware among the pieces of hardware. Although pieces of hardware are illustrated in different blocks, embodiments are not limited thereto. Some of the pieces of hardware of FIG. 1 (e.g., at least a portion of the processor 110, memory 120, and communication circuit (not shown)) may be included in a single integrated circuit, such as a system on a chip (SoC). Communication methods between components may include buses, general purpose input and output (GPIO), serial peripheral interface (SPI), mobile industry processor interface (MIPI), etc.

The processor 110 of the battery diagnosis device 100 according to an embodiment may include a hardware component for processing data based on one or more instructions. Hardware components for processing data may include, for example, an arithmetic and logic unit (ALU), a floating point unit (FPU), a field programmable gate array (FPGA), a central processing unit (CPU), a micro controller unit (MCU), and/or an application processor (AP). The number of processors 110 may be one or more. For example, the processor 110 may have a multi-core processor architecture having dual cores, quad cores, hexa cores, or octa cores.

The memory 120 of the battery diagnosis device 100 according to an embodiment may include hardware components for storing data and/or instructions input and/or output to and from the processor 110. The memory 120 may include, for example, a volatile memory such as a random-access memory (RAM) and/or a non-volatile memory such as a read-only memory (ROM). For example, the volatile memory may include at least one of dynamic RAM (DRAM), static RAM (SRAM), cache RAM, and pseudo SRAM (PSRAM). For example, the non-volatile memory may include at least one of programmable ROM (PROM), erasable PROM (EPROM), electrically erasable PROM (EEPROM), flash memory, a hard disk, a compact disc, a solid state drive (SSD), and an embedded multi-media card (eMMC).

The interface 130 of the battery diagnosis device 100 according to an embodiment may be configured to generate battery measurement values from a battery. To this end, the interface 130 may include measuring means such as a voltmeter, an ammeter, a thermometer, etc., and/or a communication module for establishing a communication link with an external device. As an example, the interface 130 may include a temperature sensor attached to the battery cell.

For example, the interface 130 may be configured to acquire a temperature profile representing a relationship between a voltage of the battery cell and a temperature of the battery cell. The interface 130 may be configured to acquire a capacity profile representing a relationship between the voltage of the battery cell and a capacity of the battery cell.

For example, the temperature profile may represent the temperature relative to the voltage of the battery cell. The temperature profile may represent a temperature change with respect to a voltage change of the battery cell.

For example, the capacity profile may represent the capacity relative to the voltage of the battery cell. The capacity profile may represent a capacity change relative to a voltage change of the battery cell.

That is, the battery diagnosis device 100 may acquire data related to a battery (or differential data obtained by changing (or differentiating) the data) using the interface 130. The battery diagnosis device 100 may acquire data related to the battery (e.g., a capacity profile or temperature profile) during a process of charging or discharging the battery cell.

In an embodiment, the battery diagnosis device 100 may acquire the temperature profile and the capacity profile based on a charging rate exceeding a designated charging rate (e.g., 0.33 C-rate).

For example, charging of a battery cell based on the charging rate exceeding the designated charging rate may be referred to as high rate charging. When charging the battery cell based on the high rate charging, since the battery cell is charged by an overvoltage, at least one of the peak values reflecting characteristics of the battery cell may not be identified in the capacity data.

For example, the battery diagnosis device 100 may use the temperature profile to identify at least one unidentified peak value. In this case, the battery diagnosis device 100 map a voltage range of the temperature profile and a voltage range of the capacity profile.

The processor 110 according to an embodiment may identify a first peak value based on the temperature profile. For example, the processor 110 may estimate a degree of degradation, which indicates the degree to which the battery cell has degraded, based on identifying a first point corresponding to the first peak value in the capacity profile. For example, the processor 110 may control the charge amount of the battery cell when the degree of degradation of the battery exceeds a designated degree of degradation (or a degree of reference degradation). For example, the processor 110 may control the charge amount of the battery cell so that the capacity of the battery cell does not exceed the designated capacity. For example, the processor 110 may control a discharge amount of the battery cell so that the capacity of the battery cell is not reduced to less than a designated capacity. However, it is not limited thereto. For example, the processor 110 may provide a signal including the degree of degradation of the battery cell to an external device based on the estimating the degree of degradation of the battery cell.

For example, the first point corresponding to the first peak value identified by the processor 110 may represent a high potential phase equilibrium state (or high potential phase transition state) occurred at a negative electrode of the battery cell. That is, the first peak value corresponding to the first point may represent the high potential phase equilibrium state occurred at the negative electrode of the battery cell. For example, the high potential may fall within an area that exceeds an average value in the entire voltage range of the battery cell.

For example, a phase equilibrium state may include a phase transition state. That is, the peak value corresponding to the first point may represent the phase equilibrium state and/or the phase transition state that occurred within the battery cell.

For example, phase equilibrium may occur several times during the process of charging or discharging the battery cell. When phase equilibrium occurs, peaks may appear in the capacity profile (e.g., the differential capacity profile) of the battery cell. That is, the phase equilibrium occurring inside the battery may be expressed in the form of a peak in the differential capacity profile of the battery cell.

For example, the peak may be a point where an instantaneous change rate of a differential capacity with respect to a voltage is zero, the instantaneous change rate of the differential capacity with respect to the voltage on a lower voltage side than a point where the instantaneous change rate is zero is positive, and the instantaneous change rate of the differential capacity with respect to the voltage on a higher voltage side than the point where the instantaneous change rate is zero is negative.

For example, the peak may be a point where an instantaneous change rate of a differential capacity with respect to a voltage is zero, the instantaneous change rate of the differential capacity with respect to the voltage on the lower voltage side than a point where the instantaneous change rate is zero is negative, and the instantaneous change rate of the differential capacity with respect to the voltage on the higher voltage side than the point where the instantaneous change rate is zero is positive.

For example, the phase equilibrium state may mean a state in which a structural and chemical state of the negative electrode material of the battery cell is stable and balanced. For example, in the phase equilibrium state, the concentration of lithium ions may be kept constant. For example, in the phase equilibrium state, a solid electrolyte interface (SEI) layer may be stably maintained. For example, in the phase equilibrium state, the voltage of the battery cell may be stably maintained.

For example, the phase transition state may include a process of switching from a phase to another phase of the battery cell. That is, a crystal structure within the battery cell may change in the phase shift state.

For example, when using a temperature profile and a capacity profile acquired based on a charging rate that is less than a designated charging rate, the battery diagnostic device 100 may identify the first point using the capacity profile among the temperature profile and the capacity profile, and thus may bypass the operation of identifying the first peak value. However, when using the temperature profile and the capacity profile acquired based on the charging rate exceeding the designated charging rate, the first point within the capacity profile cannot be identified, and thus the battery diagnosis device 100 may indirectly identify the first point in the capacity profile using the first peak value of the temperature profile.

The battery diagnosis device 100 according to an embodiment may identify a second point different from the first point. For example, the second point may correspond to a voltage lower than the voltage corresponding to the first point.

For example, the battery diagnosis device 100 may estimate the degree of degradation based on a difference between the first point and the second point. The difference between the first point and the second point may include a length between the first point and the second point.

For example, the battery diagnosis device 100 may estimate the degree of degradation by comparing the difference between the first point and the second point with a designated difference. For example, the designated difference may be acquired based on reference data including the difference between the first point and the second point of the battery cell in a beginning of life (BOL) state.

For example, the second point may represent a phase equilibrium state different from the high potential phase equilibrium state corresponding to the first point. For example, the other phase equilibrium state corresponding to the second point may precede the high potential phase equilibrium state corresponding to the first point. In other words, temporally, another equilibrium state corresponding to the second point may occur temporarily earlier than the high-potential equilibrium state corresponding to the first point. For example, a high potential phase equilibrium state corresponding to the first point may mean a sixth phase equilibrium state (or a phase transition state), and the other phase equilibrium state corresponding to the second point may mean a second phase equilibrium state (or a phase transition state).

For example, when the battery diagnosis device 100 identifies the second point, the battery diagnosis device 100 may set a higher voltage region than the second point as a region of interest. The battery diagnosis device 100 may identify a peak value corresponding to the first point by setting the region of interest. As an example, the peak value corresponding to the first point may be identified in a temperature profile corresponding to the region of interest.

The battery diagnosis device 100 according to an embodiment as described above may infer the first point indicating the high potential equilibrium state not identified in the capacity profile by using the temperature profile acquired based on the charging rate exceeding the designated charging rate. For example, the battery diagnosis device 100 may estimate the degree of degradation of the battery cell by identifying the first point indicating the high potential equilibrium using the temperature profile, independently of the charging rate.

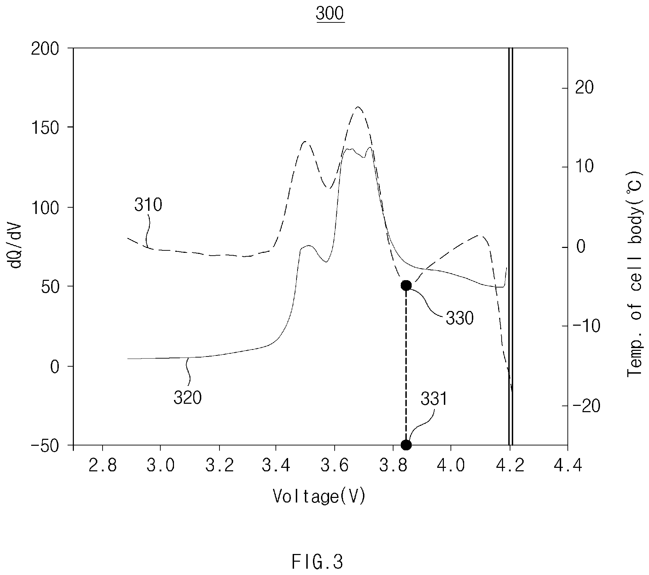

FIG. 3 illustrates an example of a graph 300 representing data related to a battery cell according to an embodiment disclosed in this document. The battery diagnosis device 100 of FIG. 3 may be referenced to the battery diagnosis device 100 of FIG. 2. For example, the graph 300 may include a capacity profile 320 (e.g., dQ/dV data) that represents a capacity change of a battery cell with respect to a voltage change of the battery cell. The capacity profile 320 may represent the capacity change of the entire battery cell with respect to the voltage change of the entire battery cell. However, it is not limited thereto. As an example, the capacity profile 320 may represent the capacity change of a positive electrode within the battery cell with respect to the voltage change of the positive electrode within the battery cell. The capacity profile 320 may represent the capacity change of a negative electrode within the battery cell with respect to the voltage change of the negative electrode within the battery cell. For example, the graph 300 may include a temperature profile 310 representing a temperature change of the battery cell with respect to the voltage change of the battery cell.

In an embodiment, the capacity profile 320 may include one or more points. For example, one or more points may be utilized in an algorithm for analyzing the quality (or state) of a battery cell.

For example, one or more points may include a point at which the slope of the graph corresponding to the capacity profile 320 changes. The point at which the slope changes may include a point at which a value of the slope changes from positive to negative (or negative to positive) based on the point. As an example, at least one of one or more points may include a point at which the slope of the graph is constant, depending on the charging rate (or charge speed) used to acquire the capacity profile 320. The point at which the slope is constant may include a point other than the point at which the value of the slope changes from positive to negative (or negative to positive) based on the point. For example, the points may represent a phase transition state or a phase equilibrium state occurred within the battery cell.

For example, the temperature profile 310 may include one or more peak values. The one or more peak values may correspond to one or more points included in the capacity profile 320. The one or more peak values may be referred to as one or more extreme values.

For example, the battery diagnosis device 100 may identify a first peak value 330 in the temperature profile 310. For example, the battery diagnosis device 100 may identify a voltage value 331 corresponding to the first peak value 330 based on identifying the first peak value 330. For example, the battery diagnosis device 100 may identify a first point corresponding to the voltage value 331 in the capacity profile 320 based on identifying the voltage value 331. The first point may represent the high potential phase equilibrium state of the battery cell that occurred for the sixth time. For example, the first point may be located at a point having a constant slope.

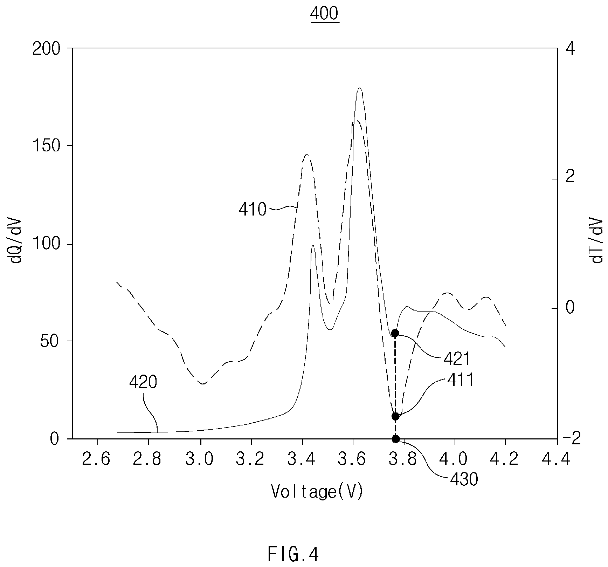

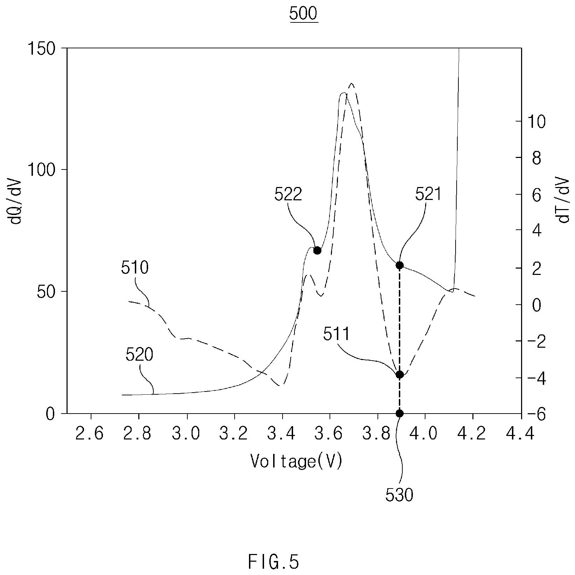

Hereinafter, with reference to FIGS. 4 and 5, the operation in which the battery diagnosis device 100 identifies the first point based on the temperature profile of the battery cell will be described in more detail.

FIG. 4 illustrates an example of a graph 400 representing data related to a battery cell according to an embodiment disclosed in this document. FIG. 5 illustrates an example of a graph 500 representing data related to a battery cell according to an embodiment disclosed in this document. The battery diagnosis device 100 of FIGS. 4 and 5 may be referenced to the battery diagnosis device 100 of FIG. 2.

Referring to FIG. 4, the graph 400 may include a temperature profile 410 and a capacity profile 420 acquired by the battery diagnosis device 100 according to an embodiment based on a charging rate (e.g., 0.05 C-rate) that is less than a designated charging rate. The temperature profile 410 may represent a temperature change with respect to a voltage change of the battery cell, and the capacity profile 420 may represent a capacity change with respect to the voltage change of the battery cell.

In an embodiment, the temperature profile 410 may include one or more peak values. The battery diagnosis device 100 may identify a first peak value 411 in the temperature profile 410. The battery diagnosis device 100 may identify a voltage value 430 corresponding to the first peak value 411. For example, the battery diagnosis device 100 may identify a point 421 corresponding to the voltage value 430 in the capacity profile 420 based on identifying the voltage value 430.

In an embodiment, since the capacity profile 420 is acquired based on a charging rate that is less than a designated charging rate, the point 421 may be referred to as a peak value in the capacity profile 420. That is, the point 421 may be referred to as a peak value at which the sign of the slope changes with the point as a reference. Since the point 421 has a characteristic that appears as a peak value, the battery diagnosis device 100 may bypass the operation using the temperature profile 410 and identify the point 421 using the capacity profile 420. However, it is not limited thereto. The battery diagnosis device 100 may identify the point 421 within the capacity profile 420 using the temperature profile 410, independently of the charging rate for acquiring battery data.

Referring to FIG. 5, a graph 500 may include a temperature profile 510 and a capacity profile 520 acquired by the battery diagnosis device 100 according to an embodiment based on a charging rate exceeding a designated charging rate (e.g., 0.33 C-rate). The temperature profile 510 may represent a temperature change with respect to a voltage change of the battery cell, and the capacity profile 520 may represent a capacity change with respect to the voltage change of the battery cell.

In an embodiment, the temperature profile 510 may include one or more peak values. The battery diagnosis device 100 may identify a first peak value 511 in the temperature profile 510. The battery diagnosis device 100 may identify a voltage value 530 corresponding to the first peak value 511. For example, the battery diagnosis device 100 may identify a first point 521 corresponding to the voltage value 530 in a capacity profile 520 based on identifying the voltage value 530.

In an embodiment, since the capacity profile 520 is acquired based on the charging rate exceeding the designated charging rate, the battery diagnosis device 100 may not be able to identify the first point 521 using the capacity profile 520. That is, the sign of the slope may not change with the first point 521 as a reference. Since the first point 521 does not have a characteristic that appears as a peak value, the battery diagnosis device 100 may identify the first point 521 in the capacity profile 520 using the temperature profile 510. In other words, when battery data (e.g., the capacity profile or temperature profile) is acquired based on the charging rate exceeding the designated charging rate, the first peak value 511 included in the temperature profile 510 may be used to identify the first point 521 included in the capacity profile 520.

The battery diagnosis device 100 according to an embodiment may identify a second point 522. The second point 522 may represent a phase equilibrium state that occurs earlier than the phase equilibrium state corresponding to the first point 521 while the battery cell is being charged. For example, the second point 522 may represent a second phase equilibrium state among phase equilibrium states that occurred while charging or discharging a battery cell.

For example, the battery diagnosis device 100 may identify a difference (or length) between the first point 521 and the second point 522. The battery diagnosis device 100 may identify the degree of degradation of the battery cell by comparing the difference between the first point 521 and the second point 522 with a designated difference. As an example, the difference between the first point 521 and the second point 522 may decrease as the battery cell degrades.

For example, the difference between the first point 521 and the second point 522 may include a difference between a voltage value corresponding to the first point 521 and a voltage value corresponding to the second point 522. For example, the difference between the first point 521 and the second point 522 may include a difference between a value corresponding to the first point 521 (e.g., a dQ/dV value) and a value corresponding to the second point 522.

The battery diagnosis apparatus 100 according to an embodiment as described above may identify the point at which the phase equilibrium state for identifying the degree of degradation of the battery cell has occurred using the temperature profile. When the battery diagnosis device 100 may not identify the point at which the phase equilibrium state has occurred using the capacity profile, the battery diagnosis device 100 may identify the point at which the phase equilibrium state has occurred using the temperature profile. The battery diagnosis device 100 may identify the degree of degradation of the battery cell using the capacity profile and the temperature profile independently of the charging speed for acquiring the capacity profile and the temperature profile. That is, the battery diagnosis device 100 may identify a point for measuring the degree of degradation of the battery cell in the capacity profile obtained based on the charging rate exceeding the designated charging rate by using the temperature profile.

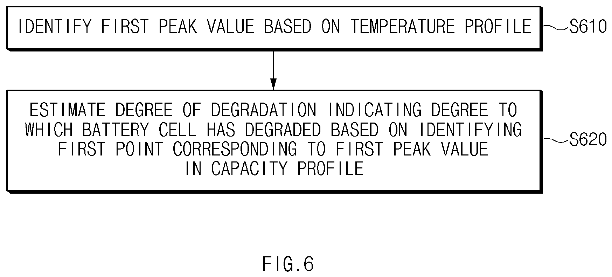

FIG. 6 shows an example of a flowchart illustrating an operation performed by a battery diagnosis device according to an embodiment disclosed in this document.

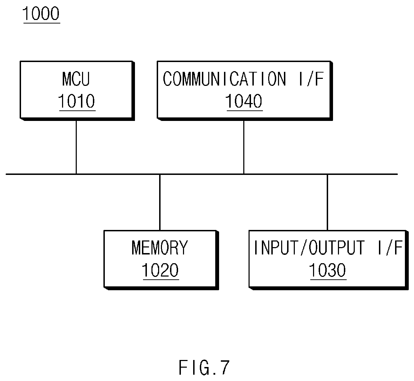

FIG. 6 is a flowchart illustrating a battery diagnosis method according to an embodiment disclosed in this document. Hereinafter, it is assumed that the battery diagnosis device 100 of FIG. 2 performs the process of FIG. 6. In addition, the operations described as being performed by the device may be understood to be controlled by the processor 110 of the battery diagnosis device 100. Each of the operations in FIG. 7 may be performed sequentially, but is not necessarily performed sequentially. For example, the order of each of the operations may be changed, and at least two operations may be performed in parallel. In addition, the operation of the battery diagnosis device 100 may be performed by a battery management system (BMS) in a vehicle, and may also be performed in various devices such as a server, cloud, charger, or charger/discharger.

Referring to FIG. 6, in operation S610, the battery diagnosis device according to an embodiment may identify a first peak value (e.g., the first peak value 511 of FIG. 5) based on a temperature profile (e.g., the temperature profile 510 of FIG. 5).

For example, the battery diagnosis device may acquire the temperature profile and the capacity profile based on the charging rate (or charge speed) that exceeds the designated charging rate (or charge speed). For example, the temperature profile may include one or more peak values. For example, the battery diagnosis device may set a range for identifying the first peak value among one or more peak values. The battery diagnosis device may identify a voltage value (e.g., the voltage value 530 of FIG. 5) corresponding to the first peak value by identifying the first peak value within the set range.

Referring to FIG. 6, in operation S620, the battery diagnosis device according to an embodiment may estimate a degree of degradation indicating the degree to which a battery cell has degraded based on identifying the first point corresponding to the first peak value in the capacity profile.

For example, the battery diagnosis device may identify the first point (e.g., the first point 521 of FIG. 5) corresponding to a voltage value corresponding to the first peak value. The first point may represent a phase equilibrium state that occurred in the battery cell.

For example, the battery diagnosis device may identify a second point (e.g., the second point 522 of FIG. 5) different from the first point. The battery diagnosis device may determine the shrinkage rate by using the difference (or length) between the first point and the second point. For example, the battery diagnosis device may determine the shrinkage rate of the battery cell by comparing the difference between the first point and the second point with the designated difference (e.g., the designated difference identified through reference data acquired from the battery cell in a BOL state). The battery diagnosis device may estimate the degree of degradation of the battery cell based on the determined shrinkage rate.

For example, the designated difference may be set based on user input. For example, the designated difference may include an average value of the difference between each of a plurality of battery cells.

For example, the battery diagnosis device may control charging of a battery cell when the degree of degradation exceeds the designated degree of degradation. The designated degree of degradation may be identified through data to extend the life of the battery cell. For example, controlling the charging of a battery cell may include an operation of setting an upper limit on the amount of charge of the battery cell, an operation of setting a lower limit on the amount of discharge of the battery cell, and/or an operation of limiting a charging rate for charging the battery cell.

FIG. 7 illustrates a computing system executing a battery diagnosis method according to an embodiment disclosed in this document.

Referring to FIG. 7, a computing system 1100 according to an embodiment disclosed in this document may include an MCU 1010, a memory 1020, an input/output I/F 1030, and a communication I/F 1040.

The MCU 1010 may be a processor that executes various programs stored in the memory 1020 (e.g., an SOH calculation program, a cell balancing target determination program, etc.), processes various data including the state of charge (SOC), state of health (SOH), etc. of a plurality of battery cells through these programs, and performs the functions of the battery diagnosis device 100 described with reference to FIGS. 2 to 6. The MCU 1010 may be, but is not limited to, a BMS, a separate PC, or the cloud.

The memory 1020 may store various programs related to calculating the SOH of battery cells and determining the target for cell balancing. Furthermore, the memory 1020 may store various data, such as SOC data and SOH data for each battery cell.

A plurality of such memories 1020 may be provided as needed. The memory 1020 may be a volatile memory or a nonvolatile memory. The memory 1020 used as the volatile memory may be RAM, DRAM, SRAM, etc. The memory 1020 used as the nonvolatile memory may be ROM, PROM, EAROM, EPROM, EEPROM, flash memory, etc. The examples of the memories 1020 listed above are only examples and are not limited to these examples.

The input/output I/F 1030 may provide an interface that allows data to be transmitted and received by connecting an input device (not shown) such as a keyboard, mouse, or touch panel and an output device (not shown) such as a display with the MCU 1010.

The communication I/F 1040 is a configuration that can transmit and receive various data with the server, and may be various devices that can support wired or wireless communication. For example, a program or various data for calculating the SOH of a battery cell or determining a balancing target may be transmitted to and received from a separately provided external server through the communication I/F 1040.

In this way, the battery diagnosis method according to an embodiment disclosed in this document may be recorded in the memory 1020 and executed by the MCU 1010.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an example of the technical idea disclosed in this document, and those skilled in the art to which the embodiments disclosed in this document pertain may make various modifications and variations without departing from the essential characteristics of the embodiments disclosed in this document. Accordingly, the embodiments disclosed in this document are intended to describe rather than limit the technical ideas of the embodiments disclosed in this document, and the scope of the technical ideas disclosed in this document is not limited by these embodiments. The scope of protection of the technical ideas disclosed in this document should be interpreted by the scope of the claims below, and all technical ideas within the equivalent scope should be interpreted as being included in the scope of rights of this document.

## Claims

1. A battery diagnosis device comprising:
an interface configured to acquire a temperature profile representing a temperature change of a battery cell with respect to a voltage change of the battery cell and a capacity profile representing a capacity change of the battery cell with respect to the voltage change of the battery cell; and
at least one processor,
wherein the at least one processor is configured to:
identify a first peak value representing a phase transition of the battery cell based on the temperature profile; and
estimate a degree of degradation, which indicates a degree to which the battery cell has degraded, based on identifying a first point corresponding to the first peak value in the capacity profile.

2. The battery diagnosis device of claim 1, wherein the at least one processor is configured to acquire the temperature profile and the capacity profile during a process of charging or discharging the battery cell.

3. The battery diagnosis device of claim 1, wherein the first point represents a high potential phase transition state occurred at a negative electrode of the battery cell.

4. The battery diagnosis device of claim 1, wherein the at least one processor is configured to:
identify a second point different from the first point based on the capacity profile and
estimate the degree of degradation based on a difference between the first point and the second point.

5. The battery diagnosis device of claim 4, wherein the at least one processor is configured to estimate the degree of degradation by comparing the difference between the first point and the second point with a designated difference.

6. The battery diagnosis device of claim 4, wherein the second point exhibits a phase transition state different from a high potential phase transition state corresponding to the first point.

7. The battery diagnosis device of claim 1, wherein the at least one processor is configured to acquire the temperature profile through the interface including a temperature sensor attached to the battery cell.

8. The battery diagnosis device of claim 1, wherein the at least one processor is configured to control a charge amount of the battery cell when the degree of degradation of the battery exceeds a degree of designated degradation.

9. A battery diagnosis method comprising:
an operation of identifying a first peak value representing a phase transition of a battery cell based on a temperature profile representing a temperature change of the battery cell with respect to a voltage change of the battery cell; and
an operation of estimating a degree of degradation, which indicates a degree to which the battery cell has degraded, based on identifying a first point corresponding to the first peak value in a capacity profile representing a capacity change of the battery cell with respect to the voltage change of the battery cell.

10. The battery diagnosis method of claim 9, further comprising:
an operation of acquiring the temperature profile and the capacity profile during a process of charging or discharging the battery cell.

11. The battery diagnosis method of claim 9, wherein the operation of estimating the degree of degradation includes:
an operation of identifying a second point different from the first point based on the capacity profile; and
an operation of estimating the degree of degradation based on a difference between the first point and the second point.

12. The battery diagnosis method of claim 11, wherein the operation of estimating the degree of degradation further includes an operation of estimating the degree of degradation by comparing the difference between the first point and the second point with a designated difference.

13. The battery diagnosis method of claim 11, wherein the second point exhibits a phase transition state different from a high potential phase transition state corresponding to the first point.

14. The battery diagnosis method of claim 9, further comprising:
an operation of acquiring the temperature profile through the interface including a temperature sensor attached to the battery cell.

15. The battery diagnosis method of claim 9, wherein the battery diagnosis method includes an operation of controlling a charge amount of the battery cell when the degree of degradation of the battery exceeds a designated degree of degradation.
